# Europäisches Patentamt
# European Patent Office
# Office européen des brevets

(19)

(11) Publication number: **0 016 176**
**B1**

(12) # EUROPEAN PATENT SPECIFICATION

(45) Date of publication of patent specification: **15.02.84**

(51) Int. Cl.³: **G 11 C 19/28, G 11 C 7/06**

(21) Application number: **79900946.9**

(22) Date of filing: **31.07.79**

(86) International application number:
**PCT/US79/00565**

(87) International publication number:
**WO 80/00387 06.03.80 Gazette 80/5**

(54) DATA STORAGE SYSTEM.

(30) Priority: **03.08.78 US 930613**

(43) Date of publication of application:
**01.10.80 Bulletin 80/20**

(45) Publication of the grant of the patent:
**15.02.84 Bulletin 84/7**

(84) Designated Contracting States:
**DE FR GB NL**

(56) References cited:
**DE - A - 2 509 567**
**US - A - 3 758 794**
**US - A - 3 814 955**
**US - A - 3 925 806**
**US - A - 3 946 368**
**US - A - 3 979 603**
**US - A - 3 999 171**
**US - A - 4 007 381**
**US - A - 4 021 682**
**US - A - 4 085 459**
**US - A - 4 139 910**

(73) Proprietor: **NCR Corporation**
**World Headquarters**
**Dayton Ohio 45479 (US)**

(72) Inventor: **WARD, William Pearson**
**9330 Sea Turtle Manor Plantation**
**FL 33324 (US)**

(74) Representative: **Robinson, Robert George**
**International Patent Department NCR Limited 206**
**Marylebone Road**
**London NW1 6LY (GB)**

(58) References cited:
**IBM TECHNICAL DISCLOSURE BULLETIN, vol.
16, no. 10, March 1974, pages 3164–3165
Armonk, U.S.A. L.G. HELLER et al.: "Charge
Transfer Compensation Circuit"**
**IEEE JOURNAL OF SOLID-STATE CIRCUITS, vol.
SC-12, no. 6, December 1977, pages 626-632
New York, U.S.A. C.H. SEQUIN et al.: "Self-
Contained Charge-Coupled Split-Electrode
Filters Using a Novel Sensing Technique"**

Courier Press, Leamington Spa, England.

**0016176**

IBM TECHNICAL DISCLOSURE BULLETIN, vol. 16, no. 4, September 1973, pages 1099-1100 Armonk, U.S.A. H.D. CHAI et al.: "Noise Compensator for Charge-Coupled Devices"
IBM TECHNICAL DISCLOSURE BULLETIN, vol. 20, no. 5, October 1977, pages 2072-2073 Armonk, U.S.A. L.G. HELLER et al.: "High Speed High Sensitivity CCD Comparator"
IEEE JOURNAL OF SOLID-STATE CIRCUITS, vol. SC-11, no. 1, February 1976, pages 18-24 New York, U.S.A. R.C. VARSHNEY et al.: "A Byte Organized NMOS/CCD Memory with Dynamic Refresh Logic"

Data storage system

Technical field

This invention relates to data storage systems of the kind including a shift register having a plurality of storage cells adapted to store binary data, and subject to undergo cell-to-cell losses in the signals representing the binary data as the signals are shifted from cell-to-cell, a detection circuit adapted to detect the binary data stored in a first one of said storage cells, and means adapted to provide first and second signals respectively dependent on the binary data stored in said first storage cell and binary data stored in a second storage cell which is adjacent to and receives the data shifted from said first storage cell, said detection circuit including comparison means adapted to compare said first and second signals thereby providing a comparison signal determining the binary data stored in said first storage cell.

The invention also relates to methods of the kind for detecting the data value of binary data stored in a first storage cell of a shift register having a plurality of storage cells, subject to undergo cell-to-cell losses in the signals representing the binary data as the signals are shifted from cell-to-cell, including the step of comparing first and second signals dependent respectively on the binary data stored in said first storage cell and binary data stored in a second storage cell adjacent to and receiving the data shifted from said first storage cell.

One example of a shift register of the kind specified is a charge transfer device such as a charge coupled device wherein charge packets representing data are serially shifted through the device.

Background art

In a CCD data storage system known from IEEE Journal of Solid State Circuits, vol. SC-11, No. 1, February 1976, pages 18—24, data is detected by a detection device for application to data output means or for recirculation through the shift register. In the detection device signals representing the data stored in a storage cell are compared with an externally generated reference signal.

Data storage systems of the kind specified are also known from IBM Technical Disclosure Bulletin, vol. 16, No. 10, March 1974, pages 3164—3165 and from US—A—3,925,806 (Strain). These known data storage systems provide some compensation for the signal distortions produced by shift register propagation.

However, these known systems have the disadvantage that their reliability is limited, particularly where binary data is propagated through the shift register.

In US—A—3999171 known analog data is passed through a CCD shift register and the value of the data at the output of the register is used to set the gain of an amplifier receiving the register output signals so as to correct for signal losses along the register. This known system is however for analog data and is relatively complex.

Disclosure of the invention

It is an object of the present invention to provide a data storage system of the kind specified wherein binary data can be read in a simple and reliable manner.

Therefore, according to the present invention, there is provided a data storage system including a shift register having a plurality of storage cells adapted to store binary data, and subject to undergo cell-to-cell losses in the signals representing the binary data as the signals are shifted from cell-to-cell, a detection circuit adapted to detect the binary data stored in a first one of said storage cells, and means adapted to provide first and second signals respectively dependent on the binary data stored in said first storage cell and binary data stored in a second storage cell which is adjacent to and receives the data shifted from said first storage cell, said detection circuit including comparison means adapted to compare said first and second signals thereby providing a comparison signal determining the binary data stored in said first storage cell, characterized in that the binary data stored in said second storage cell is known binary data.

It will be appreciated that in a system according to the invention a very reliable detection of data is achieved because of the minimization of the problem caused by cell-to-cell losses and the utilization of known stored binary data as a basis for comparison.

According to another aspect of the invention, there is provided a method for detecting the data value of binary data stored in a first storage cell of a shift register having a plurality of storage cells, subjected to undergo cell-to-cell losses in the signals representing the binary data as the signals are shifted from cell-to-cell, including the step of comparing first and second signals dependent respectively on the binary data stored in said first storage cell and binary data stored in a second storage cell adjacent to and receiving the data shifted from said first storage cell, characterized by the step of providing known binary data in said second storage cell.

Brief description of the drawings

Fig. 1 illustrates a data storage system, including a shift register and detection circuit, in accordance with the present invention.

Fig. 2 is a circuit diagram illustrating the detection circuit of Fig. 1.

Fig. 3 is a table illustrating the operation of the detection circuit shown in Fig. 2.

**Best mode for carrying out the invention**

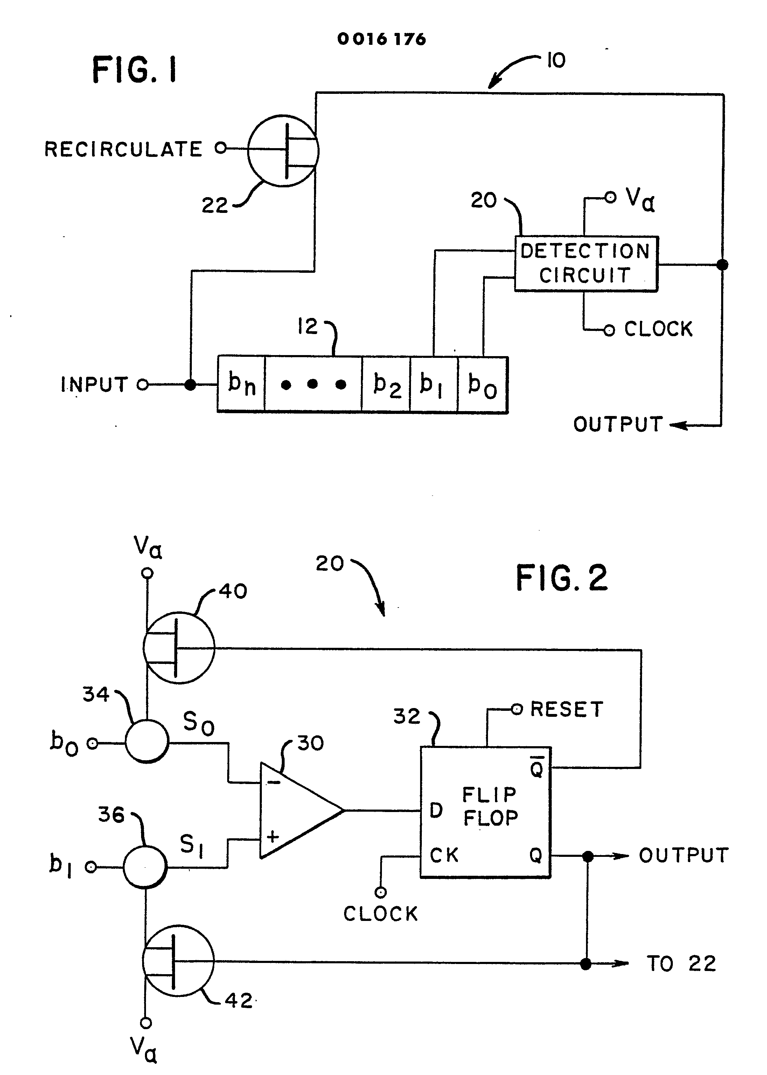

Referring now to Fig. 1, a data storage system 10 is illustrated. The data storage system 10 includes a charge transfer device, such as a charge coupled device (CCD) shift register 12. A CCD, as is well-known, stores packets of charges in potential wells, and moves or transfers the charge packets along a series of storage or cell locations, from one cell to the next, in order to function as a serial shift register. The charge level states represent data. The shifting is accomplished by proper sequential application of clock pulses (not shown). The individual cells within the shift register 12 are labeled $b_0$ through $b_n$. The illustrated storage system 10 stores binary data and each of the cells $b_0$ through $b_n$ stores a bit of data having either a logic level "0" or a logic level "1". The charge packets tend to experience charge loss as they are shifted from cell to cell in the CCD device. The losses are affected by various considerations and can vary from one device to another. For example, CCD's are sensitive to variations in temperature, clocking frequency and the physical dimensions within the device.

The two most rightward cell locations as viewed in Fig. 1, $b_0$ and $b_1$, are connected to the two data inputs of a detection circuit 20. The output of the detection circuit 20 provides, in a manner which will be discussed in greater detail later, the logic level of the data bit within the cell location $b_1$. The cell location $b_0$ is initially loaded with a reference or marker bit, and thus the shift register 12 can store a total of n-1 data bits plus a single marker bit. The marker bit is provided because data value detection is accomplished in the system 10 by sensing the difference between the voltages or signals within the two adjacent cell locations $b_0$ and $b_1$, with the data value within cell location $b_0$ always known. The marker bit value can initially be written into cell location $b_0$, and can have a binary value of either logic level "0" or logic level "1".

The actual manner in which the register 12 is constructed in order to permit the voltages or signals in the adjacent cell locations $b_0$ and $b_1$ to be sensed is unimportant for purposes of the present description. However, if register 12 is a CCD, a conventional gate, such as a "floating gate", could be physically located at each of the two cell locations $b_0$ and $b_1$ in order to provide the signals in the cell locations to the detection circuit 20.

The output of the detection circuit is provided to the input of the shift register 12 by way of a field-effect transistor (FET) 22. When data is being recirculated in the shift register, an enabling voltage is applied to the illustrated "RECIRCULATE" terminal. The FET 22 becomes conductive and the data bit at the $b_0$ cell is re-

generated by circuit 20 to its full value and passed through the FET 22 to the $b_n$ cell.

The detection circuit 20, in addition to receiving the data inputs from the cell locations $b_0$ and $b_1$, also receives a clocking signal, designated CLOCK, and an adjustment voltage, designated $V_a$. The detection circuit 20 is illustrated in greater detail in Fig. 2.

In Fig. 2, the detection circuit 20 is seen to include a sense amplifier 30 and a flip-flop 32. The amplifier 30 has a first, positive (+) input terminal and a second, negative (−) input terminal. The negative input terminal of the amplifier 30 is connected to the $b_0$ cell by a summing node 34 and the positive input terminal of the amplifier 30 is connected to the $b_1$ cell by a summing node 36. The signals from the summing nodes 34 and 36 are designated $S_0$ and $S_1$, respectively. The amplifier 30 can be a differential amplifier of conventional design that compares the signals $S_0$ and $S_1$, and at its output provides a full voltage "0" logic level signal if $S_0$ is larger, and a full voltage "1" logic level signal if $S_1$ is larger.

The summing nodes 34 and 36 are connected to the adjustment voltage $V_a$ by field-effect transistors (FET's) 40 and 42, respectively. The gate of the FET 40 is connected to the inverted output $\bar{Q}$ of the flip-flop 32 and the gate of the FET 42 is connected to the noninverted output Q of flip-flop 32. The reason for the connection of FET's 40 and 42 in this manner will become apparent later when the operation of detection circuit 20 is described. Briefly, however, the summing by nodes 34 and 36 of the voltage $V_a$ to either one of the signals from $b_0$ and $b_1$ is important when $b_0$ and $b_1$ store the same binary value. By the connection of the FET's 40 and 42 to the outputs of the flip-flop 32, the positive terminal of amplifier 30 senses a larger voltage when both $b_0$ and $b_1$ are at a "1" logic level, and the negative terminal of amplifier 30 senses a larger voltage when both $b_0$ and $b_1$ are at a "0" logic level.

Although the signal losses experienced by $b_0$ and $b_1$ are nearly identical, there will normally be a very small loss from cell-to-cell and $V_a$ should have a value at least slightly greater than the worst case cell-to-cell loss that could be present from $b_1$ to $b_0$. For a typical CCD, a value of one-half the difference between the full voltage levels of the "0" and "1" binary logic levels would be satisfactory. It should be noted, however, that $V_a$ should not exceed the difference in the full voltage values or levels of the "0" and "1" logic levels. Otherwise, an erroneous comparison could be made by amplifier 30.

The flip-flop 32 also receives a "RESET" signal which resets the flip-flop to the value of the marker bit when the marker bit is in the $b_0$ cell. The RESET signal could be generated by a source external to the detection circuit 20, such as a memory controller, or the detection circuit could include an internal counter circuit (not shown) responsive to each cell-to-cell shift within the shift register 12 so that each time the marker bit reaches the $b_0$ cell the output of the counter circuit resets the flip-flop 32. While the register 12 is mentioned as only having one marker bit, it should be appreciated that more than one marker bit could be located at spaced apart cells along the register, and that the flip-flop 32 could be reset each time one of the marker bits reaches the $b_0$ cell.

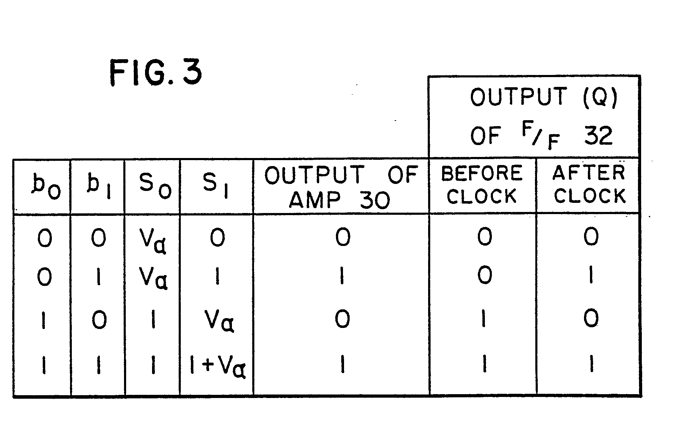

The operation of the detection circuit 20 will now be described with reference to Figs. 2 and 3. The detection circuit is initialized when the marker bit is in the $b_0$ cell. If the marker bit has been given, for example, a binary value of "0", the flip-flop 32 is reset so that a "0" logic level signal appears at the output Q of flip-flop 32.

At the initialization of the detection circuit 20, the signal at the $b_0$ cell and at the input to the summing node 34 will be at a "0" logic level and the signal from the $b_1$ cell and at the input to the summing node 36 will be at an unknown binary value, which value is desired at the output of the detection circuit 20. When the output Q of the flip-flop 32 is at a "0" logic level, the output $\overline{Q}$ is at a "1" logic level, and the FET 40 is made conductive and connects the voltage $V_a$ to the summing node 34. The output of summing node 34, $S_0$, then has a value of $V_a$ and is supplied to the negative input terminal of the amplifier 30. The FET 42, on the other hand, is not conductive, and therefore the positive terminal of the amplifier 30 receives the output of summing node 36, $S_1$, having the same value as the value of the signal from cell $b_1$.

If the signal from $b_1$ represents a "0" logic level, the signal $S_1$ will be at "0", the voltage at the negative terminal of amplifier 30 $(V_a)$ will be greater, and therefore the output of amplifier 30 will be "0", restored to its full voltage level. When the flip-flop 32 receives the CLOCK signal, the "0" logic level at its input D will be clocked into the flip-flop and appears at the output Q. On the other hand, if the signal from the $b_1$ cell represents a "1" logic level, the signal at the positive terminal of the amplifier 30 will be greater, and a "1" is provided at the output of the amplifier 30 and is clocked into the flip-flop 32. It can thus be seen that the output of the detection circuit 20 provides, with the necessary amplification to full voltage levels, the logic level of the signal from the $b_1$ cell.

When data is shifted one cell location to the right as viewed in Fig. 1, such shifting generally occurring at the same time that the flip-flop 32 receives the CLOCK signal, the data represented by the signal within the cell $b_1$ is now in the cell $b_0$. If $b_1$ was formerly at a "1" logic level, then a "1" is now in $b_0$ and at the output Q of flip-flop 32, and the FET 42 is now conductive. The positive input terminal of amplifier 30 receives the signal $S_1$ representing whatever logic level is now in $b_1$, plus the

adjustment voltage $V_a$. The negative terminal of the amplifier 30 receives the signal $S_0$ having the same value as the signal from $b_0$. If $b_1$ is now at a "1" logic level, the $S_1$ signal at the positive input terminal of amplifier 30 will be a "1" plus $V_a$, and a "1" appears at the output of amplifier 30 and is clocked into the flip-flop 32. On the other hand, if $b_1$ is at a "0" logic level, the $S_1$ signal at the positive input terminal of amplifier 30 will be at $V_a$ and, with the $S_0$ signal at the negative input terminal of amplifier 30 at a "1", a "0" appears at the output of amplifier 30 and is clocked into the flip-flop 32.

The table in Fig. 3 illustrates, for each of the values of $b_0$ and $b_1$, the resulting signals $S_0$ and $S_1$, the output of amplifier 30, and the logic level of the signal appearing at the output Q of the flip-flop 32 both before and after the CLOCK signal. It can be noted from Fig. 3 that the output of the flip-flop before the CLOCK is at the same value as $b_0$, and after the CLOCK is at the value of $b_1$.

It can thus be seen that the value of the signal in the $b_1$ cell is determined by comparing the signals from the $b_0$ and $b_1$ cells, with the value of $b_0$ being known, either because it has the value of a marker bit and the flip-flop 32 has been reset to such value, or it has the value of the bit just shifted from the $b_1$ cell, and the value of such bit has been clocked into the flip-flop. In either case, the determination of what logic level is represented by the signal from the $b_1$ cell is made by comparison with the signal from $b_0$ cell, rather than with a reference voltage, as is done in the prior art. A reliable determination is made even if large or unknown signal losses are experienced during shifting, as long as the signals representing the two binary values are not both completely lost.

**Claims**

1. A data storage system including a shift register (12) having a plurality of storage cells adapted to store binary data and subject to undergo cell-to-cell losses in the signals representing the binary data as the signals are shifted from cell-to-cell, a detection circuit (20) adapted to detect the binary data stored in a first one $(b_1)$ of said storage cells, and means adapted to provide first $(S_1)$ and second $(S_0)$ signals respectively dependent on the binary data stored in said first storage cell $(b_1)$ and binary data stored in a second storage cell $(b_0)$ which is adjacent to and receives the data shifted from said first storage cell $(b_1)$, said detection circuit (20) including comparison means (30) adapted to compare said first and second signals $(S_1, S_0)$ thereby providing a comparison signal determining the binary data stored in said first storage cell $(b_1)$, characterized in that the binary data stored in said second storage cell $(b_0)$ is known binary data.

2. A data storage system according to claim 1, characterized in that said second cell $(b_0)$

initially has reference data of a predetermined binary value stored therein.

3. A data storage system according to claim 2, characterized by adjustment means (34, 36, 40, 42) adapted to add an adjustment signal ($V_a$) to a selected one of signals which represent the data stored in said first and second cells ($b_1$, $b_0$) respectively, dependent on said known binary data, thereby providing said first and second signals ($S_1$, $S_0$) which are applied in operation to said comparison means (30).

4. A data storage system according to claim 3, characterized in that said detection circuit (20) includes a bistable device (32) arranged to have the state thereof controlled by said comparison signal, and in that there is provided resetting means adapted to reset said bistable device (32) to a state representing the binary value of said reference data when said reference data is stored in said second storage cell ($b_0$).

5. A data storage system according to claim 4, characterized in that said adjustment signal ($V_a$) has a value greater than a value corresponding to the worst case cell-to-cell loss in said shift register and less than the difference in value between the full values of the signals representing respective binary digit types.

6. A data storage system according to claim 5, characterized in that said comparison means includes a differential amplifier (30) having first and second input terminals arranged to receive said first and second signals ($S_1$, $S_0$) respectively, and arranged to provide a logic "1" or "0" output signal forming said comparison signal according as said first signal is greater or less than said second signal respectively, said adjustment means (34, 36, 40, 42) being controlled by said bistable device (32) such that when the data stored in said first and second cells is binary "0" said second signal ($S_0$) is greater than said first signal and when the data stored in said first and second cells is binary "1" said first signal ($S_1$) is greater than said second signal ($S_0$).

7. A data storage system according to claim 6, characterized in that when the data stored in said second cell ($b_0$) is binary "0", said adjustment means (34, 36, 40, 42) is controlled to add said adjustment signal ($V_a$) to said signal representing the data stored in said second cell ($b_0$) and when the data stored in said second cell ($b_0$) is binary "1", said adjustment means (34, 36, 40, 42) is controlled to add said adjustment signal ($V_a$) to said signal representing the data stored in said first cell ($b_1$).

8. A data storage system according to any one of the preceding claims, characterized in that said shift register includes a charge coupled device (12), data stored in said storage cells being represented by charge level states of said storage cells.

9. A method for detecting the data value of binary data stored in a first storage cell ($b_1$) of a shift register (12) having a plurality of storage cells subject to undergo cell-to-cell losses in the signals representing the binary data as the signals are shifted from cell-to-cell, including the step of comparing first and second signals ($S_1$, $S_0$) dependent respectively on the binary data stored in said first storage cell ($b_1$) and binary data stored in a second storage cell ($b_0$) adjacent to and receiving the data shifted from said first storage cell ($b_1$), characterized by the step of providing known binary data in said second storage cell ($b_0$).

10. A method according to claim 9, characterized by the steps of providing signals representing the binary data stored in said first ($b_1$) and second ($b_0$) storage cells respectively, and adding an adjustment signal ($V_a$) to a selected one of said data representing signals in dependence on said known binary data, thereby providing said first and second signals ($S_1$, $S_0$).

**Patentansprüche**

1. Datenspeichersystem mit einem Schieberegister (12), welches eine Vielzahl von Speicherzellen besitzt, die zum Speichern binärer Daten geeignet und Zellen-zu-Zellen-Verlusten in den die binären Daten darstellenden Signalen unterworfen sind, während die Signale von Zelle zu Zelle verschoben werden, einer Detektorschaltung (20), welche zur Feststellung der in einer ersten ($b_1$) der Speicherzellen gespeicherten Daten geeignet ist, und Vorrichtungen, die geeignet sind, erste ($S_1$) und zweite ($S_0$) Signale abzugeben, welche entsprechend abhängen von den in der ersten Speicherzelle ($b_1$) gespeicherten binären Daten und von den in einer zweiten Speicherzelle ($b_0$) gespeicherten binären Daten, die zur ersten Speicherzelle ($b_1$) benachbart ist, und die die von der ersten Speicherzelle ($b_1$) verschobenen Daten aufnimmt, wobei die genannte Detektorschaltung (20) Vergleichsvorrichtungen (30) aufweist, die geeignet sind, die ersten und zweiten Signale ($S_1$, $S_0$) zu vergleichen, wobei sie ein Vergleichssignal abgeben, das die in der ersten Speicherzelle ($b_1$) gespeicherten binären Daten bestimmt, dadurch gekennzeichnet, daß die in der zweiten Speicherzelle ($b_0$) gespeicherten binären Daten bekannte binäre Daten sind.

2. Datenspeichersystem nach Anspruch 1, dadurch gekennzeichnet, daß die zweite Zelle ($b_0$) anfangs ein Referenzdatum eines vorbestimmten Binärwertes gespeichert hat.

3. Datenspeichersystem nach Anspruch 2, gekennzeichnet durch Justiervorrichtungen (34, 36, 40, 42), welche dazu geeignet sind, ein Justiersignal ($V_a$) zu einem der Signale zu addieren, das die in der ersten bzw. zweiten Zelle ($b_0$, $b_1$) gespeicherten Daten darstellt, abhängig von den bekannten binären Daten, wobei die ersten und zweiten Signale ($S_1$, $S_0$) abgegeben werden, die in Betrieb an die Vergleichsvorrichtungen (30) angelegt werden.

4. Datenspeichersystem nach Anspruch 3, dadurch gekennzeichnet, daß die genannte Detektorschaltung (20) eine bistabile Vorrichtung (32) beinhaltet, deren zustand durch das genannte Vergleichssignal gesteuert wird und daß Rückstellvorrichtungen vorgesehen sind, welche zur Rückstellung der genannten bistabilen Vorrichtung (32) zu einem zustand geeignet sind, welcher den Binärwert des genannten Bezugsdatums darstellt, wenn das genannte Bezugsdatum in der genannten zweiten Speicherzelle ($b_0$) gespeichert ist.

5. Datenspeichersystem nach Anspruch 4, dadurch gekennzeichnet, daß das genannte Justiersignal ($V_a$) einen Wert besitzt, welcher größer als ein Wert ist, der dem Verlust von Zelle zu Zelle im schlimmsten Fall in dem genannten Schieberegister entspricht, sowie kleiner ist als die Differenz im Wert zwischen den vollen Werten der entsprechende Binärzdifftypen darstellenden Signale.

6. Datenspeichersystem nach Anspruch 5, dadurch gekennzeichnet, daß die genannten Vergleichsvorrichtungen einen Differentialverstärker (30) beinhalten, der erste und zweite Eingangsklemmen besitzt, welche genannte erste bzw. zweite Signale ($S_1$, $S_0$) empfangen können und ein Verknüpfungsausgangssignal "1" oder "0" abgibt, welches das genannte Vergleichssignal darstellt, und zwar abhängig davon, ob das genannte erste Signal größer bzw. kleiner als das genannte zweite Signal ist, wobei die genannten Justiervorrichtungen (34, 36, 40, 42) durch die genannte bistabile Vorrichtung (32) gesteuert wird und zwar derart, daß, wenn die in den genannten ersten und zweiten Zellen gespeicherten Daten eine binäre "0" sind, das genannte zweite Signal ($S_0$) größer als das genannte erste Signal ist und wenn die in den genannten ersten und zweiten Zellen gespeicherten Daten eine binäre "1" sind, das genannte erste Signal ($S_1$) größer als das genannte zweite Signal ($S_0$) ist.

7. Datenspeichersystem nach Anspruch 6, dadurch gekennzeichnet, daß, wenn das in der genannten zweiten Zelle ($b_0$) gespeicherte Datum eine binäre "0" ist, die genannten Justiervorrichtungen (34, 36, 40, 42) derart gesteuert werden, daß sie das genannte Justiersignal ($V_a$) zu dem genannten die in der genannten zweiten Zelle ($b_0$) gespeicherten Daten darstellenden Signal hinzuzählt und, wenn die in der genannten zweiten Zelle ($b_0$) gespeicherten Daten eine binäre "1" sind, die genannten Justiervorrichtungen (34, 36, 40, 42) derart gesteuert werden, daß sie das genannte Justiersignal ($V_a$) zu dem die in der genannten ersten Zelle ($b_1$) gespeicherten Daten darstellenden Signal hinzuzählt.

8. Datenspeichersystem nach einem der vorhergehenden Ansprüche, dadurch gekennzeichnet, daß das genannte Schieberegister eine ladungsgekoppelte Vorrichtung (12) beinhaltet, wobei die in den genannten Speicherzellen gespeicherten Daten dargestellt werden durch Ladungspegelzustände der genannten Speicherzellen.

9. Verfahren zum Feststellen des Datenwertes binärer Daten, die in einer ersten Speicherzelle ($b_1$) eines Schieberegisters (12) gespeichert sind, welches eine Mehrzahl von Speicherzellen besitzt, die Zellen-zu-Zellen-Verlusten in den die binären Daten darstellenden Signale unterworfen sind, während die Signale von Zelle zu Zelle verschoben werden; mit dem Schritt des Vergleichens der ersten und zweiten Signale ($S_1$, $S_0$) abhängig von den in der ersten Speicherzelle ($b_1$) gespeicherten binären Daten bzw. von den in einer der ersten Speicherzelle ($b_1$) benachbarten und von dieser die verschobenen Daten empfangenden zweiten Speicherzelle ($b_0$), gekennzeichnet durch den Schritt Vorsehen bekannter binärer Daten in der zweiten Speicherzelle ($b_0$).

10. Verfahren nach Anspruch 9, gekennzeichnet durch die Schritte Abgeben von Signalen, die die in der ersten ($b_1$) bzw. zweiten ($b_0$) Speicherzelle gespeicherten binären Daten darstellen und Addieren eines Justiersignals ($V_a$) zu ausgewählten der Signale darstellenden Daten, abhängig von den bekannten binären Daten unter Abgabe der ersten und zweiten Signale ($S_1$, $S_0$).

**Revendications**

1. Système de mémorisation de données comprenant un registre à décalage (12) ayant plusieurs cellules de mémorisation destinées à mémoriser des données binaires et sujettes à des pertes intercellulaires affectant les signaux représentant les données binaires lorsque les signaux sont translatés d'une cellule à l'autre, un circuit (20) de détection destiné à détecter les données binaires mémorisées dans une première ($b_1$) desdites cellules de mémorisation, et des moyens destinés à produire des premier ($S_1$) et second ($S_0$) signaux dépendant respectivement de la donnée binaire mémorisée dans ladite première cellule de memorisation ($b_1$) et de la donnée binaire memorisée dans une seconde cellule de mémorisation ($b_0$) qui est adjacente à ladite première cellule de mémorisation ($b_1$) et qui reçoit les données translatées de cette première cellule de mémorisation ($b_1$), ledit circuit de détection (20) comprenant des moyens de comparaison (30) destinés à comparer lesdits premier et second signaux ($S_1$, $S_0$) afin de produire un signal de comparaison déterminant la donnée binaire mémorisée dans ladite première cellule de mémorisation ($b_1$), caractérisé en ce que la donnée binaire mémorisée dans ladite seconde cellule de mémorisation ($b_0$) est une donnée binaire connue.

2. Système de mémorisation de données selon la revendication 1, caractérisé en ce que ladite seconde cellule ($b_0$) possède initialement une donnée de référence mémorisée d'une valeur binaire prédéterminée.

3. Système de mémorisation de données selon la revendication 2, caractérisé par des moyens d'ajustement (34, 36, 40, 42) destinés à additionner un signal d'ajustement ($V_a$) à l'un, choisi, de signaux qui représentent les données mémorisées dans lesdites première et seconde cellules ($b_1$, $b_0$) respectivement, suivant ladite donnée binaire connue, afin de produire lesdites premier et second signaux ($S_1$, $S_0$) qui sont appliqués, en fonctionnement, auxdits moyens de comparaison (30).

4. Système de mémorisation de données selon la revendication 3, caractérisé en ce que le circuit de détection (20) comprend un dispositif bistable (32) monté de manière que son état soit commandé par le signal de comparaison, et en ce qu'un dispositif de repositionnement est destiné à repositionner le dispositif bistable (32) dans un état représentant la valeur binaire de la donnée de référence lorsque cette dernière est mémorisée dans la seconde cellule de mémorisation ($b_0$).

5. Système de mémorisation de données selon la revendication 4, caractérisé en ce que le signal d'ajustement ($V_a$) a une valeur supérieure à une valeur correspondant à la perte intercellulaire dans le pire des cas, à l'intérieur dudit registre à décalage, et inférieure à la différence entre les valeurs complètes des signaux représentant des caractères respectifs en chiffres binaires.

6. Système de mémorisation de données selon la revendication 5, caractérisé en ce que l'élément de comparaison comprend un amplificateur différentiel (30) qui comporte des première et seconde bornes d'entrée montées de manière à recevoir lesdits premier et second signaux ($S_1$, $S_0$), respectivement, cet amplificateur étant monté de manière à produire un signal logique de sortie "1" ou "0" formant ledit signal de comparaison, selon que le premier signal est supérieur ou inférieur au second signal, respectivement les moyens d'ajustement (34, 36, 40, 42) étant commandés par ledit dispositif bistable (32) de manière que, lorsque les données mémorisées dans les première et seconde cellules ont une valeur binaire "0", le second signal ($S_0$) soit supérieur au premier signal et que, lorsque les données mémorisées dans les première et seconde cellules ont une valeur binaire "1", le premier ($S_1$) soit supérieur au second signal ($S_0$).

7. Système de mémorisation de données selon la revendication 6, caractérisé en ce que, lorsque la donnée mémorisée dans la seconde cellule ($b_0$) a la valeur binaire "0", les moyens d'ajustement (34, 36, 40, 42) sont commandés de manière à additionner le signal d'ajustement ($V_a$) au signal représentant la donnée mémorisée dans la seconde cellule ($b_0$) et, lorsque la donnée mémorisée dans ladite seconde cellule ($b_0$) a la valeur binaire "1", les moyens d'ajustement (34, 36, 40, 42) sont commandés de manière à additionner ledit signal d'ajustement ($V_a$) audit signal représentatif de la donnée mémorisée dans la première cellule ($b_1$).

8. Système de mémorisation de données selon l'une quelconque des revendications précédentes, caractérisé en ce que le registre à décalage comprend un dispositif a couplage de charge (12), les données mémorisées dans les cellules de mémorisation étant représentées par des états de niveau de charge desdites cellules de mémorisation.

9. Procédé pour détecter la valeur d'une donnée binaire mémorisée dans une première cellule de mémorisation ($b_1$) d'un registre à décalage (12) ayant plusieurs cellules de mémorisation sujettes à des pertes intercellulaires affectant les signaux représentant les données binaires lorsque les signaux sont translatés d'une cellule à une autre, comprenant l'étape qui consiste à comparer des premier et second signaux ($S_1$, $S_0$) dépendant respectivement de la donnée binaire mémorisée dans ladite première cellule de mémorisation ($b_1$) et de la donnée binaire mémorisée dans une seconde cellule de mémorisation ($b_0$) adjacente à ladite première cellule de mémorisation ($b_1$) et destinée à recevoir la donnée translatée de cette première cellule de mémorisation ($b_1$), caractérisé par l'étape qui consiste à utiliser une donnée binaire connue dans ladite seconde cellule de mémorisation ($b_0$).

10. Procédé selon la revendication 9, caractérisé par les étapes qui consistent à produire des signaux représentant les données binaires mémorisées dans lesdites première ($b_1$) et seconde ($b_0$) cellules de mémorisation, respectivement, et à additionner un signal d'ajustement ($V_a$) à l'un, choisi, desdits signaux représentatifs de données suivant ladite donnée binaire connue, afin de produire lesdits premier et second signaux ($S_1$, $S_0$).

**0016 176**

**FIG. 1**

RECIRCULATE

22

20

$V_\alpha$

DETECTION CIRCUIT

CLOCK

12

INPUT

$b_n$ • • • $b_2$ $b_1$ $b_0$

OUTPUT

10

$V_\alpha$

40

20

**FIG. 2**

34

$S_0$

$b_0$

30

32

RESET

$\overline{Q}$

36

$S_1$

$b_1$

D

FLIP FLOP

CK

Q

OUTPUT

CLOCK

42

TO 22

$V_\alpha$

## FIG. 3

| $b_0$ | $b_1$ | $S_0$ | $S_1$ | OUTPUT OF AMP 30 | OUTPUT (Q) OF $F/F$ 32 | |
| --- | --- | --- | --- | --- | --- | --- |
| | | | | | BEFORE CLOCK | AFTER CLOCK |
| 0 | 0 | $V_\alpha$ | 0 | 0 | 0 | 0 |
| 0 | 1 | $V_\alpha$ | 1 | 1 | 0 | 1 |
| 1 | 0 | 1 | $V_\alpha$ | 0 | 1 | 0 |
| 1 | 1 | 1 | $1+V_\alpha$ | 1 | 1 | 1 |